# EUROPÄISCHE PATENTSCHRIFT

(11) **EP 0 993 653 B1**
(45) Veröffentlichungstag und Bekanntmachung des Hinweises auf die Patenterteilung: **28.08.2002**
(21) Anmeldenummer: 97943659.9
(22) Anmeldetag: 20.10.1997
(51) Int. Cl.: G06K 19/073

(54) **VERFAHREN UND ANORDNUNG ZUM SCHUTZ VON ELEKTRONISCHEN RECHENEINHEITEN, INSBESONDERE VON CHIPKARTEN**
METHOD AND ARRANGEMENT FOR PROTECTING ELECTRONIC COMPUTING UNITS, IN PARTICULAR CHIP CARDS
PROCEDE ET DISPOSITIF POUR PROTEGER DES UNITES DE CALCUL ELECTRONIQUES, NOTAMMENT DES CARTES A PUCE

(30) Priorität: 22.10.1996 AT 1858996
(43) Veröffentlichungstag der Anmeldung: 19.04.2000
(73) Patentinhaber: Posch, Reinhard, 8010 Graz (AT)
(72) Erfinder: Posch, Reinhard, 8010 Graz (AT)
(74) Vertreter: Wildhack, Helmut, Dipl.-Ing. Dr.
(86) Internationale Anmeldenummer: AT9700225
(87) Internationale Veröffentlichungsnummer: WO98018102

(56) Entgegenhaltungen:
- FR-A- 2 738 971
- US-A- 5 060 261
- US-A- 5 175 424
- US-A- 5 465 349

## Beschreibung

Die Erfindung betrifft ein Verfahren gemäß dem Oberbegriff des Patentanspruches 1. Des weiteren betrifft die Erfindung eine Anordnung gemäß dem Oberbegriff des Patentanspruches 12.

Bekannt ist der Schutz von Daten und Programmen, die in elektronischen Einheiten bzw. Schaltungen enthalten sind, durch Verschlüsselung dieser Daten und Programme oder durch elektrische und/oder mechanische, den Zugriff bzw. den Zutritt verhindernde Schutzmaßnahmen, wie z.B. Codekarten für eine Zutrittsberechtigung bzw. die Anordnung derartiger Einheiten in Sicherheitsräumen usw. Wird bei derartig gesicherten Einheiten der vorgesehene Schutz ausgeschaltet bzw. durchdrungen, so wird ein Ausspähen des gegebenenfalls verschlüsselt enthaltenen Inhalts der elektronischen Einheiten möglich. Als Beispiel wird dazu auf mit Codekarten gesicherte Türen von zutrittsgesicherten Rechenanlagen verwiesen. Bei einer Reihe von Recheneinheiten bzw. Datenträgern, z.B. Chips auf Chipkarten, erfolgt eine Sicherung gegen ein Ausspähen von Daten und Programmen lediglich durch Verschlüsselung dieser Daten; eine Sicherung gegen unerlaubten Zugriff zum Chip ist minimal oder nicht gegeben; bei einer Chipkarte ist ein mechanischer Zugriff auf die Daten bzw. deren Entnahme meist nach chemischer Entfernung der Kunststoffschicht mit einer durch eine vorhandene Passivierungsabdeckung des Chips durchgestochenen Tastnadel möglich.

Gemäß der US PS 5,060.261 werden Dehnungsmessstreifen auf die zu schützende Schaltung aufgebracht bzw. in die Ummantelung eingebettet. Diese Dehnungsmessstreifen werden mit Strom beaufschlagt und die entsprechenden Widerstandwerte abgenommen. Diese Dehnungsmessstreifen stellen keinen Teil der auf die zu schützende Schaltung aufgebrachten Ummantelung dar und sind eigenständige Sensoreinheiten, die auf Veränderungen der Ummantelung reagieren. Es wird keine Signatur gebildet sondern es wird als Reaktion auf die von dem Dehnungsmessstreifen erhaltenen Messwerte entweder einen Betrieb des Mikroprozessors zugelassen oder verhindert.

Die FR-A-2,738.971 gibt die Merkmale aus dem Oberbegriff der Ansprüche 1 und 12 wieder.

Das wesentliche Ziel der Erfindung ist somit ein Schutz von elektronischen Einheiten gegen ein Ausspähen, insbesondere durch mechanische Manipulationen bzw. Angriffe jeglicher Art. Ein weiteres wesentliches Ziel der Erfindung ist es zu verhindern, dass selbst für den Fall, dass mechanisch Zutritt zu der elektronischen Einheit erlangt wird, ein Ausspähen bzw. Auslesen und ein Weiterverwenden von Daten und/oder Programmen, die in der elektronischen Einheit enthalten sind und/oder ein ordnungsgemäßer weiterer Betrieb dieser Einheit nach dem Zugriff unmöglich gemacht wird. Schließlich ist es weiteres Ziel der Erfindung, mit einer derart geschützten Einheit den Schutz von von dieser Einheit unabhängigen Gegenständen zu erreichen.

Diese Ziele werden bei einem Verfahren der eingangs genannten Art durch die in Anspruch 1 angeführten Merkmale erreicht. Bei einer Anordnung der eingangs genannten Art wird dieses Ziel durch die in Patentanspruch 12 angeführten Merkmale erreicht.

Grundlage für die erfindungsgemäße Vorgangsweise ist eine Feststellung der Unversehrtheit der bei einem unerwünschten Zugriff zu der zu schützenden elektronischen Einheit zu überwindenden Ummantelung. Jede Verletzung bzw. Beschädigung der Ummantelung durch eine mechanische oder anders geartete Einwirkung beim Zugriff verändert unwiderruflich und unnachahmbar deren Eigenschaften, insbesondere deren elektrische Eigenschaften. Eine Verletzung der Ummantelung führt dazu, daß die Einheit nicht mehr ordnungsgemäß in Funktion gesetzt werden kann, weil die bei der Initialisierung der Einheit ermittelte Signatur zur Programmabarbeitung bzw. Entschlüsselung der ursprünglich gespeicherten Daten und/oder Programmen benötigt wird nicht zur Verfügung steht und nicht mehr erstellt werden kann oder weil die Einheit bei Feststellung einer sich gegenüber der ursprünglich ermittelten Signatur veränderten Signatur ihre Funktion einstellt. Die Einheit ist durch die Ummantelung geschützt bzw. befindet sich im Inneren der Ummantelung, und agiert von dieser geschützten Lage aus. Jeder Versuch, mechanisch Zutritt zur Einheit zu erhalten, ist zum Scheitern verurteilt, da jeder Zugriff eine mechanische Beschädigung der Ummantelung bewirkt, sei es z.B. durch Anbringung von Öffnungen oder Versuche, die Schutzschicht zu penetrieren, wodurch es zu einer bleibenden Veränderung ihrer Eigenschaften und somit der Signatur kommt. Bei Anordnung einer entsprechenden Zahl von Signalaufgabestellen und Meßpunkten, z.B. in dem Ausmaß von jeweils vier Stellen bzw. Punkten je cm², wird es bereits mit geringem Meßaufwand gut möglich, durch Nadelstiche auf dieser Fläche von 1 cm² hervorgerufene Eigenschaftsänderungen der Ummantelung festzustellen.

Aufgrund der erfindungsgemäßen Vorgangsweise erhält ein Eingreifer durch Manipulationen auf technisch-physikalischer Ebene, insbesondere durch mechanischen Angriff keine relevanten Informationen bezüglich der Daten und/oder Programme, die in der Einheit unter Verwendung der Signatur gespeichert vorliegen oder abgearbeitet werden; dies insbesondere deshalb, da die bei der Initialisierung eingespeicherten Daten und/oder Programme mit der Signatur verschlüsselt sind, diese Signatur aber vorteilhafterweise nicht abgespeichert wird. Somit ist bei jeder Inbetriebnahme die Signatur neu zu ermitteln, was erfolgreich nur möglich ist, solange die Ummantelung bezüglich ihrer vermessenen Eigenschaften invariant verbleibt. Besonders vorteilhaft ist eine derartige Vorgangsweise für den Schutz von Chips, insbesondere VLSI-Chips, wie sie in Chipkarten enthalten sind.

Prinzipiell ist es möglich, Mikroprozessoren, Recheneinheiten, Platinen oder auch beliebig große, diese Einheiten enthaltende Einrichtungen mit derartigen Schutzschichten bzw. Ummantelungen, gegebenenfalls auf Teilbereichen oder über ihre gesamten Oberflächen zu versehen. Die geschützten Einheiten stehen lediglich über die zum Datentransfer vorgesehenen Übertragungseinheiten, z.B. Leitungen, Antennen, Sender für Magnetimpulse oder elektrische Impulse, Datenleitungen usw. mit externen elektronischen Einrichtungen in Verbindung. Zur Ermittlung der Signatur bzw. zur Feststellung der Unversehrtheit der Ummantelung oder zur Überprüfung der Signatur bzw. zur gewünschten Verwendung der Signatur während des Betriebs der Einheit, sind in der Einheit entsprechende Daten und/oder Programme a prion gespeichert enthalten bzw. bei der Initialisierung zumeist mit der Signatur verschlüsselt eingespeichert worden, die eine entsprechende Funktion der Einheit gewährleisten, jedoch ohne von außen her bei dieser Tätigkeit beeinflußt werden können.

Das vorliegende Verfahren verhindert zwar nicht einen mechanischen bzw. gewaltsamen Zutritt bzw. Zugriff zu den elektronischen Einheiten oder ein Abfühlen des Inhaltes dieser Einheiten, jedoch wird das Gewinnen von "brauchbaren" Informationen bei der Attacke gänzlich verhindert; das Resultat dieser die Signatur selbst unwiderruflich abändernden Attacke ist es, daß aufgrund der geänderten Signatur bzw. nicht mehr ordnungsgemäß erfolgenden Entschlüsselung der gespeicherten Daten und/oder Programme ein Fehlverhalten der Einheit eintritt und diese Einheit somit völlig unbrauchbar geworden ist.

Die Signatur der Ummantelung ist nicht nachbildbar, da die bei der Initialisierung ermittelte ursprüngliche Signatur nicht bekannt und vorteilhafterweise auch nicht gespeichert ist und auch die bei einer Verletzung der Ummantelung hervorgerufenen Änderungen der Signatur nicht erkannt werden können. Des weiteren können die dem initialen Ermittlungsverfahren für die Signatur zugrundeliegenden Daten und Parameter der Einheit nicht ausgelesen werden, da programmäßig Vorkehrungen gegen ein derartiges Auslesen vorgesehen werden können und ferner eine Entschlüsselung der gespeicherten Daten nur bei Kenntnis der ursprünglichen, bei der Attacke aber veränderten, Signatur in richtiger Weise erfolgen könnte. Für den Fall aber, daß die Signatur durch einen mechanischen Eingriff in nicht behebbarer und nicht nachahmbarer Weise abgeändert worden ist. sind allerdings die gespeicherten Daten und Programme unwiderruflich verloren. Es ist zwar möglich, die Einheit, soferne sie durch den Zugriff nicht Schaden erlitten hat, als Bauteil weiter zu verwenden bzw. neu zu initialisieren bzw. zu programmieren; die in ihr enthaltene Funktion bzw. enthaltenen Daten sind jedoch unwiderruflich verloren.

Unter Signatur wird jede unter Verwendung von bei unverletzter Ummantelung invariant bleibenden Größen bzw. Meßwerten ermittelte Wertezusammenfassung verstanden; diese Zahl wird mit einer vorgegebenen Stellenanzahl bzw. auf diese Stellenanzahl gerundet festgelegt.

Vorteilhafte Ausführungsformen der Erfindung sind der folgenden Beschreibung, den Zeichnungen und den Patentansprüchen zu entnehmen.

Im folgenden wird die Erfindung anhand der Zeichnungen näher erläutert.

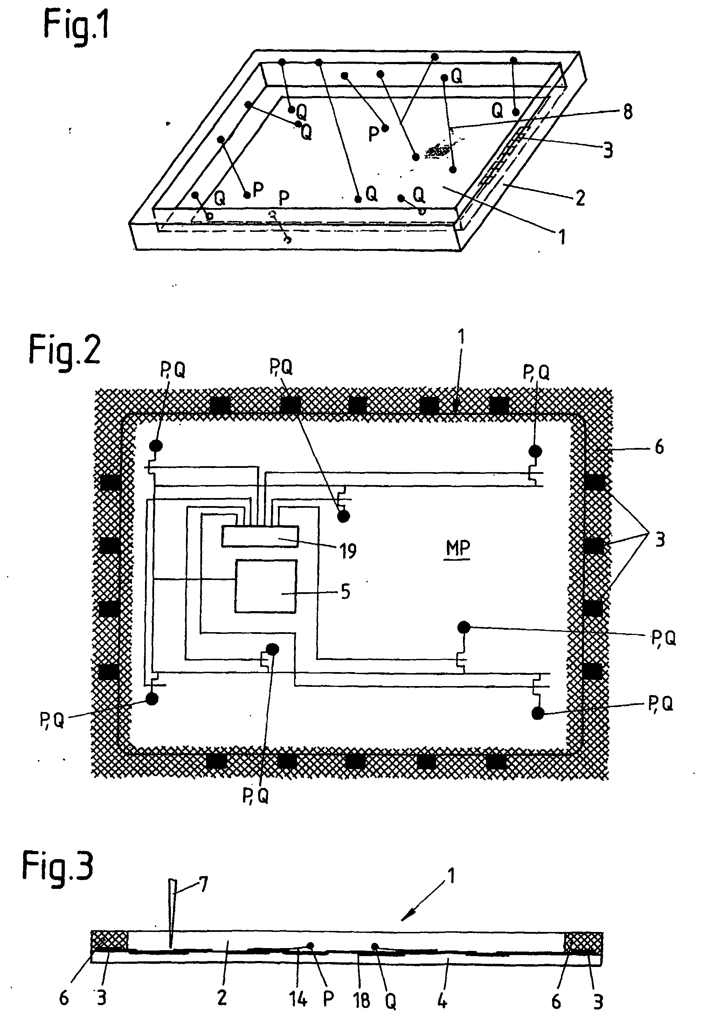

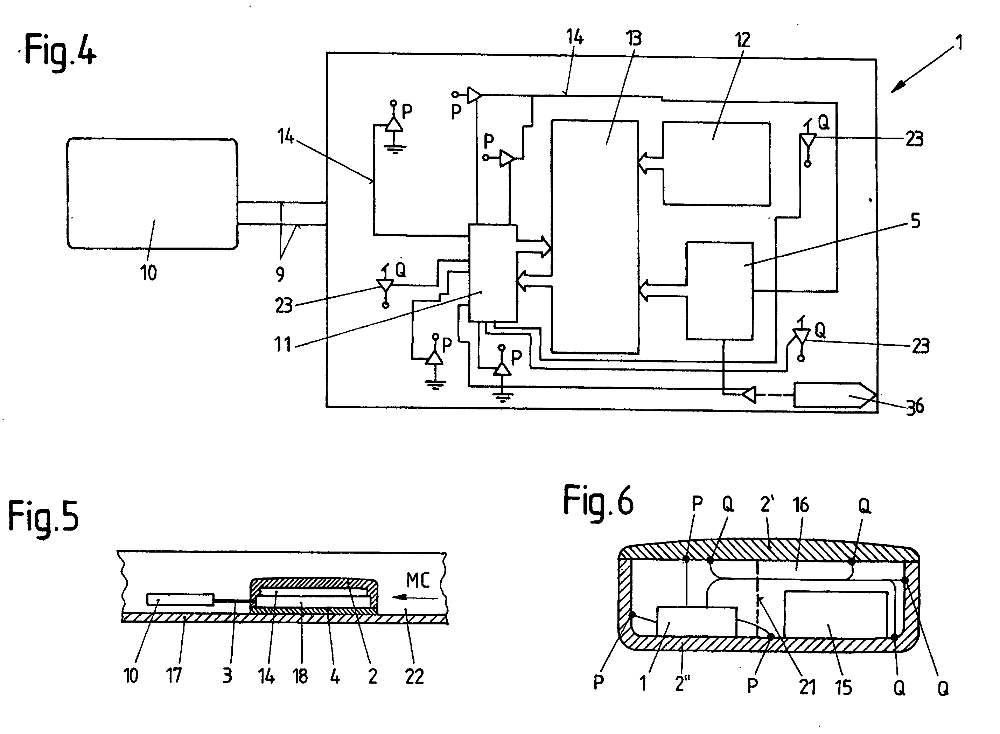

Fig. 1 zeigt das Prinzip einer erfindungsgemäß gesicherten Einheit, Fig. 2 und 3 zeigen schematisch eine Draufsicht und einen Schnitt durch eine erfindungsgemäße Einheit. Fig. 4 zeigt schematisch den Schaltungsaufbau einer erfindungsgemäßen Einheit und Fig. 5, 6, 7 und 8 schematisch Anwendungsbeispiele.

Fig. 1 zeigt schematisch eine erfindungsgemäß geschützte Einheit 1, im vorliegenden Fall einen Modul bzw. eine mit Hardware bestückte Platine, der bzw. die von einer Schutzschicht bzw. Ummantelung 2 allseitig umgeben ist. Diese Ummantelung 2 kann eine die Einheit 1 ein-, mehr- oder allseitig umgebende (Kunststoff)Schicht sein, die vorteilhafterweise zumindest längs einer Dimension bezüglich ihrer elektrischen und/oder elektromagnetischen Eigenschaften inhomogen ist. Eine derartige Inhomogenität kann z.B. durch Änderungen der Dicke der (Kunststoff)Schicht und/oder durch Einschluß von nicht bzw. nicht leicht mit dem Schichtmaterial z.B. Glas, Polymeren bzw. Kunststoff, Gummi, Metall- bzw. Halbmetallfilmen, Papier od.dgl. mischbaren, unregelmäßig verteilten Materialien bewirkt werden, insbesondere, wenn diese Materialien z.B. Metallpigmente, Metallfäden, Rußpartikel, Kohlefasern od.dgl. sind. Bei der Wahl dieser Materialien sollte auch darauf Rücksicht genommen werden, daß im Falle einer mechanischen Beschädigung relativ große Änderungen der Eigenschaften der Ummantelung bewirkt werden, sodaß Änderungen in der durch diese geänderten Materialeigenschaften bedingten Werte der Signatur entsprechend groß und leicht feststellbar sind. Vorteilhafterweise liegt die elektrische Leitfähigkeit der Ummantelung zwischen der eines Isolators und der eines metallischen Leiters, um die Empfindlichkeit der Meßsensoren und die Anzahl der Stellen P, Q in Grenzen halten zu können. Die Dicke der Ummantelung 2 ist nicht von grundsätzlicher Bedeutung und hängt vom Anwendungsfall ab.

Als zu schützende Einheiten 1 kommen insbesondere Prozessoren, Recheneinheiten, Chips, Mikroprozessoren bzw. alle elektronischen Bauteile bzw. Konfigurationen in Frage. die selbsttätig Rechenoperationen bzw. selbständig die vorgegebenen Schritte zur insbesondere initialen Ermittlung einer Signatur bewältigen bzw. ein entsprechendes Programm abarbeiten können bzw. alle Einrichtungen und Gegenstände, die derartige Einheiten 1 umfassen.

In Fig. 2 ist schematisch als zu schützende Einheit 1 ein nicht im Detail dargestellter Mikroprozessor MP gezeigt, der Anschlüsse 3 besitzt, die aus der Ummantelung 2 herausgeführt sind. Wie Fig. 3 im Schnitt zeigt, ist in diesem Fall der Mikroprozessor MP nur auf seiner Oberfläche von der Ummantelung 2 abgedeckt. Die Mikropads bzw. Anschlüsse 3 können auf übliche Weise mit einer Abdeckschicht 6 gegen elektrischen Kontakt mit der Ummantelung 2 abgedeckt sein und die Ummantelung 2 schützt den Mikroprozessor MP gegen einen mechanischen Angriff auf seiner diesbezüglich empfindlichen Oberfläche. Ein Angriff gegen den Mikroprozessor MP auf dessen Unter- bzw. Trägerseite 4 würde diesen bereits durch den stattfindenden Angriff selbst zerstören.

Um entsprechende Verbindungen zwischen der zu schützenden Einheit 1 und der Ummantelung 2 für die Signalbeaufschlagung in Signalaufgabestellen P und für die Messung der Meßwerte in Meßstellen Q zu erstellen, kann insbesondere bei Chips oder Mikroprozessoren die oberste Aufbauschichte 18 dieser Einheiten (Fig. 5) selbst herangezogen werden oder es werden entsprechende elektrische Leiter(bahnen) 14, insbesondere in der obersten Struktur eines Mikroprozessors MP, verwendet bzw. ausgebildet, die an den Signalaufgabestellen P und Meßstellen Q mit der Ummantelung 2 in Verbindung stehen. Es ist insbesondere bei Chipkarten vorteilhaft, wenn diese Stellen sehr klein, in der Größenordnung von einigen µm², ausgebildet werden; bei Platinenummantelungen sind Stellen mit Flächen im mm²-Bereich durchaus möglich. Zur Ausbildung der Signalaufbringungsstellen P und der Meßstellen Q können die Leiterbahnen 14 bis auf kleine leitende Bereiche mit einer elektrisch isolierenden Schicht abgedeckt werden und diese Bereiche stehen mit der Ummantelung 2 kontaktmäßig in Verbindung.

An Signalaufgabestellen P werden von der Einheit 1 selbst Signale, insbesondere elektrische Signale bzw. Signalimpulse, z.B. Strom und/oder Spannungswerte und/oder elektromagnetische Signale (Felder), beliebiger Art angelegt. Diese Signale werden vom Mikroprozessor MP bzw. von der Einheit 1 selbst bzw. von von der Einheit gesteuerten Signalgeneratoren gemäß den bei der Initialisierung unabänderlich vorgegebenen Daten und/oder Programmen erzeugt und gegebenenfalls über eine Verteileinrichtung, z.B. einen Selektor 19 oder einen Buffer 11 an zumindest eine, vorzugsweise eine Anzahl von Signalaufgabestelle(n) P angelegt. Ein oder eine Mehrzahl dieser Signal(e) wird (werden) mit definierter Größe und/oder Zeitdauer gleichzeitig oder in vorgegebener zeitlicher Reihenfolge an die festgelegten Signalaufgabestellen P angelegt.

In den Meßstellen Q werden mit Sensoren, z. B. elektromagnetischen Meßeinheiten bzw. Analog/Digitalwandler 5, die von der Signalbeaufschlagung resultierenden Meßgrößen abgenommen. Die Ermittlung bzw. Abnahme der Meßwerte erfolgt gleichzeitig oder zeitverzögert zu der Signalaufbringung für eine definierte Zeitspanne und/oder zu definierten Zeitpunkten, gegebenenfalls gleichzeitig für mehrere Meßstellen Q. Es ist auch möglich, eine statische Signalaufbringung und eine statische Messung vorzunehmen.

Prinzipiell ist es auch möglich, an einer Signalaufgabestelle P mehrere Signale hintereinander aufzugeben. Vorteilhafterweise wird jedoch derart vorgegangen, daß in einer unveränderlich vorgegebenen Mehrzahl von lagemäßig invarianten Signalaufgabestellen P unveränderlich definierte, insbesondere für die einzelnen Signalaufgabestellen unterschiedliche Signale an die Ummantelung 2 angelegt werden und daß an einer unveränderlich vorgegebenen Mehrzahl von lagemäßig invarianten Meßstellen Q die resultierenden Meßwerte in vorgegebener Weise abgenommen werden. Die Aufgabe der Signale und die Ermittlung der Meßwerte erfolgt immer nach denselben invarianten Kriterien, sodaß bei jedem Signalaufgabe-Meßwertermittlungs-Zyklus dieselben Resultate zu erwarten sind. Diese Resultate bleiben invariant, solange die Ummantelung 2 unveränderten Aufbau bzw. unveränderte Eigenschaften besitzt und sind für die Schutzschicht bzw. Ummantelung 2 und somit auch für geschützte Einheit 1 charakteristisch. Sobald eine Veränderung der Signatur der Ummantelung 2 durch mechanische oder eine andere Veränderung, z. B. Durchbohren oder Anritzen, ihres Aufbaus eintritt, geht die bei der Initialisierung ermittelte und seit diesem Zeitpunkt invariant gültige Signatur unwiderruflich verloren und da eine geänderte Signatur von der Einheit für die Entschlüsselung der gespeicherten Daten und/oder Programme bzw. für ihren Betrieb nicht verwendet werden kann, ist ein sinnvoller Betrieb dieser Einheit nicht mehr möglich.

Die erhaltenen Meßwerte können entweder in der erhaltenen Form zu einer Signatur zusammengefaßt werden oder sie werden zur Signaturermittlung mittels vorgegebener Funktionen mathematisch miteinander verknüpft, z.B. kann ein Zahlenvektor der Meßwerte als Signatur für die Ummantelung bestimmt werden. Die Signatur könnte auch von der Zahl gebildet werden, die durch mathematische Abänderung der Meßwerte, z.B. Einsetzen der Meßwerte in Funktionen als Veränderliche ermittelt wird. Jede derart ermittelte Signatur bzw. Zahl bleibt invariant bzw. kann in derselben Form bzw. Größe immer wieder ermittelt werden, solange die Ummantelung 2 bezüglich ihrer Eigenschaften invariant bleibt. An sich können auch die von der Einheit 1 an die Ummantelung 2 abgegebenen Signale in der Signatur Berücksichtigung finden. Auch weitere invariante Daten könnten in der Signatur berücksichtigt werden; auch das Einsetzen der ermittelten Meßwerte in eine (HASH)-Funktion ist möglich; die sich ergebenden Funktionswerte können Teil der bzw. die Signatur sein. Die Ermittlung der Signatur erfolgt jedoch immer auf die bei der Initialisierung vorgegebene Weise.

Die dem Mikroprozessor bzw. Rechner für seine Funktion bzw. seinen Betrieb aufgegebenen Daten und/oder Programme werden bei der Initialisierung der Einheit 1 zumindest teilweise mit der initial ermittelten Signatur verschlüsselt gespeichert, sodaß bei jedem Betriebsbeginn diese Daten und/oder Programme sinnvollerweise nur dann abgearbeitet werden können, wenn für diese Abarbeitung - gegebenenfalls innerhalb vorbestimmter Grenzen - die zur Verschlüsselung eingesetzte Signatur bei der bei Betriebsbeginn jeweils neuerlich erfolgenden Signaturermittlung richtig erhalten wird. Es wird somit vor jeder neuen Betriebsaufnahme die Signatur neu ermittelt und entweder mit der initial ermittelten Signatur verglichen oder es wird vorgesehen, daß die unter Verwendung der initialen Signatur verschlüsselt gespeicherten Daten und/oder Programme zwangsläufig nur mit der neuen Signatur entschlüsselt bzw. abgearbeitet werden können. In beiden Fällen führt eine Diskrepanz zwischen der initialen und neu ermittelten Signatur zu einer Fehlfunktion der Einheit Vorteilhafterweise wird die initial ermittelte Signatur nicht gespeichert, sondern wird gelöscht bzw. verworfen, nachdem sie zum Verschlüsseln der initial aufgegebenen Daten und/oder Programme verwendet wurde. Damit wird die Sicherheit gegen Zugriff bzw. Entschlüsselung des Inhaltes der Einheit erhöht.

Fig. 4 zeigt schematisch einen Aufbau eines mit ergänzenden elektronischen Bauteilen 5, 11 und Leitungen 14 versehenen Mikrochips, wobei von dem Prozessor MP über einen Buffer 11 elektrische Signale an die Signalaufgabestellen P abgegeben werden. Der Empfang der Meßgrößen von den Meßstellen Q erfolgt über einen Meßsensor 23 und den Analog/Digitalwandler 5. Es kann vorgesehen sein, daß sowohl der Buffer 11 als auch der Analog/Digitalwandler 5 einen Selektor umfassen, mit dem die Signale gleichzeitig und/oder der Reihe nach an eine Mehrzahl von Signalaufgabestellen P angelegt werden können bzw. eine Anzahl von Meßsensoren 23 bzw. Meßstellen Q gleichzeitig oder der Reihe nach abgetastet werden können. Die geschützte Einheit 1 kann über eine Datenaustauschleitung 9 mit einer externen Einheit 10 kommunizieren, ohne daß der Schutz für die elektronische Einheit 1 in irgendeiner Weise beeinträchtigt ist. In gleicher Weise könnte auch mit einer in der Einheit 1 enthaltenen und von der Ummantelung 2 geschützten Datenübertragungseinrichtung, z.B. einer Magnet- und/oder Sendeimpulse empfangenden und/oder abgebenden Kommunikations-Einheit bzw. einer Antenne, ein Datenaustausch mit der Außenwelt vorgenommen werden. Der Mikroprozessor MP exekutiert aus dem RAM 12. An die Signalaufgabestellen P kann bei Bedarf ein VSS- oder ein VCC-Pegel angelegt werden, somit kann auch die Signalintensität als Meßwert herangezogen werden.

Es ist einfach, die Leitungen 14, die Meßstellen P und/oder Q, Signalgeneratoren und Meßsensoren, Analog/Digitalwandler 5 bzw. Buffer 11 entweder zusätzlich in vorhandene elektronische Recheneinheiten zu integrieren oder mittels bereits in der elektronischen Einheit 1 vorhandenen Leitungen bzw. Schaltbauteilen zu realisieren. In dem üblicherweise vorhandenen Speicher 12, der an den Mikroprozessor MP angeschlossen ist, kann die Signatur gespeichert werden bzw. Signaturvergleiche können dort erfolgen bzw. erfolgt die Speicherung der initial aufgegebenen Daten und/oder Programme.

In Fig. 3 ist der Angriff gegen eine geschützte elektronische Einheit, im vorliegenden Fall ein Mikroprozessor MP, so wie er in Fig. 2 in Draufsicht dargestellt ist, mittels einer Nadel 7 dargestellt. In dem Augenblick, in dem die Nadel 7 die Ummantelung 2 durchdringt, bewirkt die Verletzung der Ummantelung 2 eine unwiderrufliche Veränderung der Signatur. Angedeutet sind ferner eine Signalaufgabestelle P und eine Meßstelle Q, die mit entsprechenden Leiterbahnen 14 an den Mikroprozessor MP angeschlossen sind.

Zur Ermittlung einer Signatur könnte z.B. vorgesehen sein, daß gleichzeitig oder der Reihe nach an fünf Signalaufgabestellen P die Spannungswerte von z.B. +3,+1,+4,0,+1/2 Volt angelegt werden und an einer Anzahl von Meßstellen Q die dort auftretenden Spannungs- und/oder Stromwerte bzw. deren Verläufe und/oder deren Werte gegebenenfalls nach einer bestimmten Zeitspanne als Meßwerte abgenommen werden. Die Meßwerte werden sodann allenfalls nach einer vorgegebenen mathematischen Umformung zur Ausbildung einer Signatur bzw. Zahl herangezogen. Prinzipiell ist es auch möglich, durch entsprechende Ausbildung der Signalgeneratoren und Signalaufgabestellen P und Meßsensoren bzw. Meßstellen Q kapazitive Signale bzw. elektrische Felder als Signale einzusetzen bzw. als Meßgröße zu messen.

Sofern eine elektronische Einheit von einer Ummantelung 2 auf mehreren Seiten umhüllt wird, ist es vorteilhaft, Meßpunkte Q und/oder Signalaufgabepunkte P an jeder dieser Flächen vorzusehen. Eine typische Anzahl von Meßpunkten Q und Signalaufgabestellen P ist zumindest jeweils 20 bis 40 Signalaufgabestellen und Meßpunkte pro cm² der Ummantelung 2. Die Anzahl der Meßstellen Q und Signalaufgabestellen P hängt auch von der Größe und Art der Signale bzw. von dem Material der Ummantelung 2 ab. Aus Fig. 1 ist ersichtlich, daß an die Signalaufgabestellen P und an die Meßstellen Q elektrische Leiter 8 angeschlossen sind, welche in verschiedener Länge und/oder verschiedener Dicke und/oder verschiedener Lage in die Ummantelung 2 hineinreichen. Damit kann die Inhomogenität der Ummantelung 2 hervorgerufen bzw. verstärkt und die Signalaufgabe bzw. die Messung der resultierenden Meßgrößen erleichtert werden. Die Form der zu schützenden elektronischen Einheit 1 ist eher nicht relevant, da Ummantelungen 2 aus Kunststoff oder nahezu vergleichbaren Materialien auf alle beliebig gestalteten Oberflächen bzw. um Gegenstände herum aufgebracht werden können.

Des weiteren ist zu bemerken, daß es in der Praxis nahezu unmöglich ist, auch auf zwei gleiche Einheiten 1 identische Ummantelungen 2 aufzubringen, da bereits aufgrund von Herstellungsunregelmäßigkeiten, Oberflächenungenauigkeiten usw., die auf an sich gleich gestaltete Einheiten 1 aufgebrachten Ummantelungen 2 bereits unterschiedliche Eigenschaften besitzen, die für die Ermittlung einer für die Ummantelung charakteristischen Signatur in ausreichender Zahl unterschiedliche Meßwerte zur Verfügung stellen. Es würde auch ausreichen, bei identischen Ummantelungen die Lage der Signalaufgabestellen P und der Meßstellen Q von zwei Einheiten 1 zu variieren, um für diese Einheiten charakteristische und unterschiedliche Signaturen zu erhalten. In die Signatur der Ummantelung 2 gehen ferner nicht nur die Eigenschaften der Ummantelung 2 ein, sondern auch (Oberflächen)Eigenschaften der zu schützenden Einheit 1 ein, insbesondere dann, wenn die Einheit 1 flächig mit der Schutzschicht bzw. Ummantelung 2 in Verbindung steht. Allenfalls wird deshalb zwischen der Ummantelung 2 und einer Schutzschicht eine Isolierschicht angebracht. An sich könnte bereits eine Berührung bzw. ein Anlegen eines elektrischen oder elektromagnetischen Feldes die Signatur - allerdings reversibel - verändern, sofern nicht für eine ausreichende Abschirmung der Ummantelung 2 gegen derartige Einflüsse vorgesehen ist.

Als Sensoren 23 für die Meßwerte können entsprechende analoge Schaltungen eingesetzt werden, die an Analog/Digitalwandler 5 angeschlossen sind. Es können an sich beliebige Einrichtungen zur Ermittlung der Meßwerte vorgesehen bzw. an den Mikroprozessor bzw. Rechner angeschlossen sein.

Wie in Fig. 6 dargestellt, könnte auch zwischen der zu schützenden Einheit 1 und der Ummantelung 2 ein entsprechender Freiraum 16 ausgebildet werden, in dem zu schützende Gegenstände 15 angeordnet werden können. Die elektronische Einheit 1 und der Gegenstand 15 sind allseitig durch eine obere Ummantelung 2' und eine Basis-Ummantelung 2" gegen Zugriff geschützt und zumindest an einer der beiden Ummantelungen 2' sind Signalaufgabepunkte P und Meßstellen Q ausgebildet. Mit einer Zwischenwand 21 könnten die Einheit 1 und der Gegenstand 15 getrennt angeordnet werden. An sich wäre es auch möglich, z. B. die Basis-Ummantelung 2" aus Stahl oder anderem Widerstand gegen Zutritt leistendem Material auszubilden und darauf die von der Einheit 1 überwachte Ummantelung 2' als Schutz gegen unerlaubten Zutritt aufzubringen. Sofern die Basis-Ummantelung 2" bei einem Zugriff zum Gegenstand beschädigt wird, ist dies sichtbar; sofern die elektronisch geschützte obere Ummantetung 2' verletzt wird, bedingt dies eine Fehlfunktion der Einheit 1 aufgrund der veränderten Signatur. Daraus kann festgestellt werden, ob versucht wurde, sich dem schützenden Gegenstand 15 anzunähern. Die in Fig. 6 dargestellte Anordnung kann noch mit einer Umhüllung bzw. Schutzhülle abgedeckt bzw. umschlossen werden.

Fig. 5 zeigt eine Anordnung, bei der auf einem Träger 17 ein Mikrocomputer MC angeordnet ist, dessen struktureller Aufbau 18 auf einer unteren Trägerschicht 4 ausgebildet wurde und auf dem Leiterbahnen 14 aufgebracht bzw. ausgebildet sind, die durch die Ummantelung 2 nach oben abgedeckt sind. Die Ummantelung 2 kann mit einer Deckschicht 22 abgedeckt werden, die die Signaturwerte der Ummantelung 2 aber eher nicht mitbestimmen soll. Über eine Anschlußleitung 3 steht der zu schützende Mikrocomputer MC mit einer Dateneingabe- und/oder Datenausgabeeinheit 10 in Verbindung, die von der Deckschicht 22 ebenfalls abgedeckt ist. Eine derartige Anordnung kann insbesondere bei einer Scheck- bzw. Bankomatkarte mit Chip- bzw. Mikroprozessor vorgesehen werden. Ein Zugriff von seiten des Trägers 17 durch die Basisschicht 4 des Mikroprozessors MC zerstört diesen unwiderruflich; ein Zutritt durch die Ummantelung 2 zerstört die Signatur und damit ebenfalls die Funktion des Mikroprozessors, sodaß die Einheit unbrauchbar geworden ist.

Es ist möglich, während des Betriebs der elektronischen Einheit, d.h. während der Datenverarbeitung, die Signatur in bestimmten Abständen zu überprüfen und mit einer Weiterverarbeitung der Daten nur dann fortzufahren, wenn die Signatur mit einer gespeicherten vorangehend oder bei der Initialisierung ermittelten Signatur übereinstimmt bzw. als invariant beurteilt worden ist.

Als aufzugebende Signale kommen unter Umständen auch Signalfolgen in Frage, bei denen gleiche oder unterschiedliche Signale bei den Signalaufgabestellen P der Ummantelung aufgegeben werden. Konstruktiv einfach ist es, wenn lediglich eine einzige Signalaufgabeeinheit vorgesehen ist, die an eine Anzahl von Signalaufgabestellen gleichzeitig oder in einer bestimmten Reihenfolge die Signale aufgibt bzw. nur ein einziger Meßwertaufnehmer vorgesehen ist, der die Meßstellen gleichzeitig oder der Reihe nach abfühlt.

Die Ummantelung 2 kann durchsichtig oder undurchsichtig sein; vorteilhafterweise ist die Ummantelung 2 undurchsichtig, um keine Hinweise auf die präzise Lage der Signalaufgabestellen P und Meßstellen Q zu geben. Über die Ummantelung können beliebige weitere Schichten, Abdeckungen od. dgl. aufgebracht werden.

In Fig. 4 ist beispielsweise ein über den Analog/Digitalwandler 5 an die Einheit 1 bzw. den Rechner angeschlossener Temperatursensor 6 dargestellt, mit dem die jeweilige Temperatur der Ummantelung 2 festgestellt werden kann. Da insbesondere die elektrischen und/oder elektromagnetischen Kennwerte der Ummantelung 2 temperaturabhängig sind, ist die jeweilige Temperatur der Schutzschicht 2 zum Zeitpunkt der Signaturermittlung von Bedeutung. Im Falle unterschiedlicher Temperaturen der zu schützenden Einheit 1 bei der Initialisierung bzw. bei jeweiligen Betriebsbeginnen oder Temperaturänderungen während des Betriebs würden allenfalls unterschiedliche Signaturen ermittelt werden und sich die entsprechenden Folgen einstellen. Es ist somit vorteilhaft, für eine bestimmte Anzahl von Temperaturbereichen jeweils bestimmte unveränderliche Werte der Signatur der Ummantelung 2 im Zuge der Initialisierung zu ermitteln bzw. festzulegen. Die für die einzelnen Temperaturbereiche ermittelten Signaturen S_{T}, vorteilhafterweise aber nur die Differenzwerte ΔS dieser für die einzelnen Temperaturbereiche ermittelten Signaturen S_{T} zu einer Norm-Signatur S_{NORM}, die bei einer gewählten Basis- bzw. Normtemperatur ermittelt wurde, werden in der Einheit 1 bei der Initialisierung gespeichert (ΔS = S_{T}- S_{NORM}). Die bei der Initialisierung im folgenden der Einheit 1 aufgegebenen Daten und/oder Programme werden zumindest teilweise mit der Norm-Signatur S_{NORM} verschlüsselt. Vor oder im Betrieb der Einheit 1 stellt diese die Signatur S_{T} für die Ummantelung 2 bei der gerade herrschenden Temperatur fest und berechnet aus dieser ermittelten Signatur S_{T} und dem gespeicherten Differenzwert ΔS für denjenigen Temperaturbereich, in den die herrschende Temperatur der Ummantelung 2 fällt, gemäß obiger Gleichung die Norm-Signatur S_{NORM} mit der die Entschlüsselung der gespeicherten Daten und/oder Programme erfolgt. Ist die Ummantelung 2 beschädigt worden, wird ein unrichtiger Wert für die Signatur S_{T} ermittelt mit allen Folgen.

Wenn in den Speichern der zu schützenden Einheit lediglich Differenzwerte ΔS der für einzelne Temperaturbereiche ermittelten Signaturen S_{T} und einer Norm-Signatur S_{NORM}, die z.B. bei 25°C ermittelt wurde, enthalten sind, so wäre sogar das Ausspähen der Differenzwerte ΔS nicht aussagekräftig, da die Norm-Signatur S_{NORM} nicht ermittelt werden kann.

Bei der Ermittlung der Signatur, insbesondere der Signaturen S_{T} für einzelne Temperaturbereiche, wird vorteilhafterweise derart vorgegangen, daß die ermittelten Signaturwerte bzw. Zahlen gerundet werden, derart, daß die letzte gerundete Stelle innerhalb dieses jeweiligen Temperaturbereiches völlig invariant bleibt. Um den Temperaturgang der Signatur in dem Intervall zu begrenzen werden allerdings so wenig wie möglich Stellen abgeschnitten bzw. werden Zehnerübergänge bzw. die Bit-Sprunggrenzen hauptsächlich durch Veränderung der aufgegebenen Signale im Zuge der Initialisierung ausgeglichen. Ist etwa eine Signatur bzw. Zahl gemäß der Erfindung zu "runden", so wird darauf geachtet, daß bei der Wiederermittlung der Signatur der gleiche Signaturwert entsteht. Man hat daher zu achten, daß kein Meßwert w nach der Rundung aufgrund einer Temperatur- oder Meßtoleranz einmal W und das nächste Mal W+1 ergibt. Demzufolge wird der Meßwert w auf n Stellen abgeschnitten. Liegt der abgeschnittene Wert am Rande des Wertebereiches (besonders nahe der 0 oder des größten möglichen abgeschnittenen Wertes), dann werden andere Signale an die Signalpunkte angelegt, woraus andere Meßwerte resultieren und dies solange bis die letzte Stelle der Signatur für die Grenztemperaturen des Temperaturbereiches gemessen, mit Sicherheit innerhalb dieses Stellenwertes bleibt und diesen Stellenwert nicht nach oben überschreitet.

Bei einer Rundung einer Signatur auf 5 Kommastellen würde die Zahl
34,345325123217218 auf 34,34532 gerundet werden, aber die Zahlen
34,34532001778787 bzw.

34,34532989898567 würden verworfen, weil sie bei einer weiteren Messung eventuell nicht eindeutig identifizierbar bzw. reproduzierbar wären.

Zur Vorgehensweise ist zu bemerken, daß es kein Problem darstellt, die Signalwerte im Sinne der Reproduzierbarkeit im Speicher zu haben, da dadurch keine verwertbare Information über die Meßwerte und damit über die Signatur, die nicht gespeichert werden sollte, resultiert. Die für die Signatur ermittelten Meßwerte können beispielsweise modulo einer Primzahl multipliziert werden.

Für die Initialisierung der elektronischen Einheit 1 wird Sorge getragen, daß diese elektronische Einheit 1 ein Programm besitzt, das eine Signaturermittlung selbständig vornimmt und sämtliche, nach dieser Signaturermittlung für die Initialisierung erhaltene Daten und/oder Programme zum Teil oder zur Gänze mit der ermittelten Signatur verschlüsselt, speichert und abarbeitet. Im Zuge des Betriebs der Einheit 1 von dieser gespeicherte Daten werden mit der jeweils neu ermittelten oder der allenfalls gespeicherten initial ermitttelten Signatur verschlüsselt, gespeichert bzw. abgearbeitet.

Prinzipiell können anstelle von elektrischen und/oder elektromagnetischen Signalen auch Schallsignale, Stoßwellen, Schwingungssignale usw. von der Einheit 1 mit entsprechenden Signalgebern an die Ummantelung 2 angelegt und an den Meßstellen die Meßwerte mit entsprechenden Meßsensoren abgenommen werden, um mit diesen Meßwerten eine Signatur auszubilden. Die Weiterleitung von Schallwellen, Schwingungen usw. in der Ummantelung 2 hängt direkt von deren Aufbau ab; wird der Aufbau mechanisch verändert, so verändern sich die abgenommenen Meßwerte, da die Signalübertragung in der Ummantelung 2 verändert worden ist.

Es ist vorteilhaft, wenn die bei der Initialisierung ermittelte Signatur nicht gespeichert wird, um ein Ausspähen und damit Entschlüsseln der initial gespeicherten Daten und/oder Programme zu verhindern. Es bringt jedoch bereits Vorteile, wenn die initial ermittelte Signatur gespeichert wird und bei jeder Inbetriebnahme ein Vergleich der initial gespeicherten mit der neu ermittelten Signatur erfolgt; damit kann einerseits der bei Initialisierung der Einrichtung erforderliche Programmieraufwand verringert werden; des weiteren gleichen sich die Signaturen unterschiedlicher Einheiten mit Sicherheit nicht, sodaß auch bei Ausspähen der Signatur einer Einheit keinerlei Rückschlüsse auf die Signaturen von anderen Einheiten gezogen werden können. Von Vorteil ist es, wenn auch bei der Ermittlung der Signaturen für einzelne Temperaturbereiche die Norm-Signatur gemessen bei Normal-Temperatur, nicht gespeichert wird.

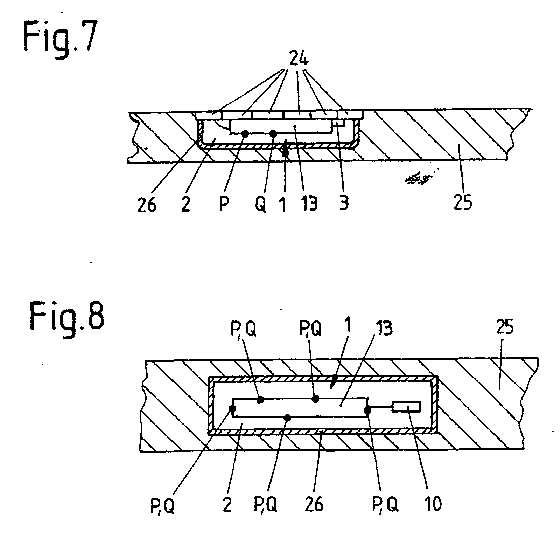

Fig. 7 und 8 zeigen Ausführungsformen von erfindungsgemäß ausgebildeten Chipkarten. Fig. 7 zeigt eine Chipkarte 25 mit Kontakten 24 und Fig. 8 zeigt eine kontaktlose Chipkarte 25. Die von einem Chip gebildete elektronische Einheit 1 ist im Fall der Fig. 7 mit Kontakten 24 versehen, die zu einem entsprechenden Datenaustausch mit externen Einheiten dienen. Der Chip 1 selbst ist im wesentlichen bis auf seine Kontaktfläche von einer Ummantelung 2 umgeben, die ihrerseits mit einer Isolationsschicht 26 gegenüber dem Material der Chipkarte 25 isoliert ist. Mit P und Q sind die Signalaufgabestellen und die Meßstellen schematisch dargestellt. Die Verbindung der Kontakte 24 mit dem Chip 1 erfolgt über entsprechende Leiter 3. Das Material der Chipkarte 25 kann an sich beliebig gewählt werden; ein unerwünschter Zutritt zum Chip 1 von seiten der Kontakte 24 her zerstört den Chip 1; ein Zutritt von seiten der Ummantelung 2 zerstört die Signatur unwiderruflich.

Die Ummantelung 2 kann unter Umständen auch mit der Einbettungsmasse 25 identisch sein bzw. könnte auch ein Kleber sein, mit dem die Isolierschichte 26 festgehalten wird.

Die in Fig. 8 dargestellte Chipkarte 25 zeigt eine kontaktlose Chipkarte, bei der auch die Antennenspule 10 in die Ummantelung 2 eingeschlossen ist. Es ist durchaus möglich, daß auch die Antenne 10 außerhalb der Ummantelung bzw. der Isolationsschicht 26 in das Material der Chipkarte 25 eingebettet ist. Im vorliegenden Fall ist somit die elektronische Einheit bzw. der Chip 1 allseitig von der Ummantelung 2 geschützt.

Die wesentlichen Vorteile der erfindungsgemäßen Vorgangsweise sind, daß ein Eindringversuch nicht zu einer Zerstörung der zu schützenden Einheit oder der Ummantelung führt, sondern zur Situation, daß die im Bauteil vorhandene Information nicht mehr entschlüsselbar und daher nicht verwendbar wird. Die Anordnung ist so getroffen, daß sie sich besonders für Microchips eignet. Die Sicherung erfolgt mit einer nicht von außen reproduzierbaren Signatur, die aus der Unregelmäßigkeit des Abdeckmaterials bzw. der Ummantelung abgeleitet wird. Die Methode ist damit auch für alle nichtflüchtigen Speicher, die schützenswerte Information enthalten, geeignet. Ein Löschen der Information und gesonderte Sensoren in diesem Bereich sind zum Schutz der Information daher nicht notwendig.

## Patentansprüche

1. Verfahren zum Schutz von elektronischen Recheneinheiten, Prozessoren, Prozessorschaltungen, Mikroprozessoren oder Chips oder von derartige Einheiten enthaltenden Gegenständen gegen unerwünschten Zugriff, wobei
- zumindest die einem Angriff oder Ausspähen ausgesetzte Seite oder Fläche der zumindest einen Prozessor und/oder Rechner und/oder Chip umfassenden Einheit (1) oder des Gegenstandes zumindest teilweise mit einer Ummantelung bzw. Schutzschicht (2) versehen oder abgedeckt wird,
- wobei an zumindest einer invariant festgelegten Signalaufgabestelle (P) an die und/oder in die Ummantelung (2) von der Einheit (1) definierte elektrische und/oder elektromagnetische Signale, vorzugsweise Strom- und/oder Spannungssignale, angelegt und/oder eingeleitet wurden,
- wobei von der mit der in zumindest einer Dimension inhomogene elektrische und/oder elektromagnetische Eigenschaften aufweisenden Ummantelung geschützten Einheit (1) elektrische und/oder elektromagnetische Messwerte, vorzugsweise Messwerte betreffend Widerstand, Kapazität, Strom, Spannung, magnetische Felder und/oder der zeitliche Verlauf dieser Messwerte, an zumindest einer invariant festgelegten Messstelle (Q) an und/oder in der Ummantelung ermittelt bzw. gemessen werden,
- wobei diese Mess- und/oder Signalwerte und gegebenenfalls weitere von der mechanischen Unversehrtheit der Ummantelung (2) abhängige Messwerte zu einer bei unverletzter Ummantelung invariant bleibenden, für die unversehrte bzw. die durch ihre mit den angelegten Signalen untersuchten Eigenschaften definierte Ummantelung (2) zu einer für die Ummantelung zum Zeitpunkt der Vermessung charakteristischen Signatur (S) zusammengefaßt werden,
- und wobei zumindest ein Teil der der Einheit (1) bei ihrer Initialisierung aufgegebenen Daten und/oder Programme unter Einbindung dieser bei der Initialisierung ermittelten Signatur (s) verschlüsselt wird,
**dadurch gekennzeichnet,**
**dass** bei der Initialisierung für eine Anzahl von unterschiedlichen Temperaturintervallen der Ummantelung (2) jeweils die für das Temperaturintervall charakteristische Signatur (S_{T}) ermittelt wird und
**dass** bei der Überprüfung einer vor Inbetriebnahme oder im Betrieb neuerlich ermittelten Signatur der Wert der charakteristischen Signatur (S_{T}) desjenigen Temperaturintervalles zu Vergleichszwecken herangezogen wird, in dem die zum Zeitpunkt der Neuermittlung der Signatur gemessene Temperatur der Ummantelung (2) liegt.

2. Verfahren nach Anspruch 1, **dadurch gekennzeichnet, dass** für aufeinanderfolgende Temperaturintervalle die jeweils charakteristische Signatur (S_{T}) ermittelt wird.

3. Verfahren nach Anspruch 1 oder 2, **dadurch gekennzeichnet, dass** die Ermittlung der Signatur (S) im Zuge der Initialisierung der Einheit (1) bzw. des Rechners erfolgt oder dass vor einer oder vor jeder Inbetriebnahme und/oder auch während des Betriebes der Einheit, von der Einheit (1) selbst eine neuerliche Ermittlung der Signatur (S) der Ummantelung (2) unter Zugrundelegung von denselben Bedingungen und Vorgangsweisen wie bei der Initialisierung der Einheit vorgenommen wird, oder dass bei jeder Inbetriebnahme die Signatur (S) neu ermittelt und diese neu ermittelte Signatur (S) zum Entschlüsseln der in dieser Einheit verschlüsselt gespeicherten Daten und/oder Programme herangezogen wird.

4. Verfahren nach einem der Ansprüche 1 bis 3, **dadurch gekennzeichnet, dass** die im Zuge der Initialisierung ermittelte Signatur (S) nach Verwendung zur Verschlüsselung zumindest eines Teiles der nachfolgend eingegebenen Daten und/oder Programme verworfen oder nicht gespeichert oder unwiderruflich gelöscht wird oder dass die im Zuge einer Inbetriebnahme neuerlich ermittelte Signatur (S) nach Verwendung zum Ver- und/oder Entschlüsseln von gespeicherten und/oder zur Speicherung erhaltenen Daten und/oder Programmen verworfen oder nicht gespeichert oder unwiderruflich gelöst wird.

5. Verfahren nach einem der Ansprüche 1 bis 4, **dadurch gekennzeichnet, dass** die Auswahl und Reihenfolge der Beaufschlagung der vorhandenen Signalaufgabestellungen (P) und die Auswahl und Reihenfolge der Abtastung der Messstellen (Q), der Art und Größe der Signale, mit denen die Signalaufgabestellungen (P) beaufschlagt werden, und die Art und Weise, in der die Messwerte ermittelt und zur Signatur (S) geformt werden, immer nach einem in der zu schützenden Einheit (1) durch bei der Initialisierung originär gespeicherten Daten und/oder Programme nach einem unabänderlich festgelegten Modus vorgenommen wird.

6. Verfahren nach einem der Ansprüche 1 bis 5, **dadurch gekennzeichnet, dass** zumindest ein oder alle Messwert(e) in der ermittelten Form oder Größe oder in einer mathematisch abgewandelten oder veränderten Form oder nach Einsetzen des(r) Messwerte(s) als Veränderliche in eine HASH-Funktion zur Bildung der Signatur (S) oder des Zahlenwertes der Signatur (S) herangezogen werden.

7. Verfahren nach einem der Ansprüche 1 bis 6, **dadurch gekennzeichnet, dass** die Einheit (1) nur nach Feststellung oder Verwendung einer unverändert gebliebenen oder einer nur innerhalb von vorgegebenen Grenzen geänderten Signatur (S) den ordnungsgemäßen Betrieb aufnimmt oder in den ordnungsgemäßen Betriebszustand versetzt wird.

8. Verfahren nach einem der Ansprüche 1 bis 7, **dadurch gekennzeichnet, dass** zur Herstellung der Ummantelung (2) unterschiedliche oder nicht oder nicht gut miteinander mischbare Substanzen, vorzugsweise Kunstharze, Glas, Gummi einerseits und Metallteilchen, Kohlefasern, Rußpartikel anderseits, vermischt werden oder zumindest ein Beschichtungsmaterial ungleichmäßig aufgetragen wird.

9. Verfahren nach einem der Ansprüche 1 bis 8, **dadurch gekennzeichnet, dass** die Beaufschlagung der Signalaufgabestellen (P) mit Signalen und die Ermittlung der Messwerte zur initialen Festlegung der Signatur (S) und eine neuerliche Ermittlung oder eine Überprüfung der Invarianz der Signatur (S) vor jeder Inbetriebnahme der Einheit ausschließlich von der mit der Ummantelung (2) geschützten Einheit (1) selbst vorgenommen wird.

10. Verfahren nach einem der Ansprüche 1 bis 9, **dadurch gekennzeichnet,**
- **dass** nach Ermittlung der jeweiligen Signaturen (S_{T}) für eine Anzahl von unterschiedlichen, insbesondere aufeinanderfolgenden, Temperaturintervallen der Ummantelung (2) lediglich die Differenz (ΔS) zwischen den für die einzelnen Temperaturintervalle ermittelten Signaturen (S_{T}) und einer bei einer vorgegebenen Normaltemperatur bei der Initialisierung ermittelten Norm-Signatur (S_{NORM}) in der Einheit (1) abgespeichert werden,
- **dass** zumindest ein Teil der Einheit (1) insbesondere bei der Initialisierung aufgegebenen Daten und/oder Programme mit der Norm-Signatur (S_{NORM}) verschlüsselt werden und
- **dass** gegebenenfalls bei einer Inbetriebnahme der Einheit (1) aus den für die einzelnen Temperaturintervalle gespeicherten Signatur-Differenzen (ΔS) der herrschenden Temperatur der Ummantelung (2) entsprechende Werte der Signatur-Differenz (ΔS) herangezogen und zu diesem Wert der bei der herrschenden Temperatur ermittelte Wert der Signatur (S_{T}) addiert und damit die Norm-Signatur (S_{NORM}) bei Normaltemperatur ermittelt wird.

11. Verfahren nach einem der Ansprüche 1 bis 10, **dadurch gekennzeichnet, dass** bei der Überprüfung einer vor Inbetriebnahme oder im Betrieb neuerlich ermittelten Signatur der Wert der Norm-Signatur (S_{NORM}) für die Überprüfung der Unversehrtheit der Ummantelung (2) bzw. für die Entscheidung betreffend die Zulässigkeit der Inbetriebnahme der Einheit (1) und/oder das Abschalten derselben herangezogen wird.

12. Anordnung zum Schutz von elektronischen Einheiten (1), die zumindest eine Recheneinheit, Prozessoreinheit, einen Mikroprozessor und/oder einen Chip umfassen, oder von derartige Einheiten (1) umfassenden Gegenständen gegen unerwünschten Zugriff,
- wobei zumindest die einem Angriff ausgesetzte Seite oder Fläche der Einheit (1) mit einer Schutzschicht oder Ummantelung (2) zumindest teilweise versehen oder abgedeckt ist,
- wobei die Einheit (1) zumindest eine Aufgabeeinrichtung (11) umfasst, mit der zumindest eine Signalaufgabestelle (P) an und/oder in der mit schwer identisch nachbildbaren elektrischen und/oder elektromagnetischen Eigenschaften ausgebildeten Ummantelung (2)mit definierten, elektrischen und/oder elektromagnetischen Signalen, vorzugsweise Strom- und/oder Spannungssignalen, beaufschlagbar ist,
- wobei die Einheit (1) zumindest eine Empfangseinrichtung (5) zur Ermittlung oder Messung zumindest einer Messgröße oder eines Messwertes umfasst, die (der) von den aufgegebenen Signalen an zumindest einer oder an einer Mehrzahl von an oder in der Ummantetung (2) liegenden Messstelle(n) (Q) hervorgerufen sind (ist),
- wobei von der Einheit (1) im Zuge ihrer Initialisierung zumindest einer der oder alle ermittelten Messwerte zur Ermittlung einer für die Unversehrtheit der Ummantelung (2) charakteristischen und bei unverletzter Ummantelung invariant bleibenden Signatur (S) verwendet ist bzw. sind,
- wobei die Einheit (1) einen Speicher (12) aufweist, in dem zumindest ein Teil der im Zuge der Initialisierung aufgegebenen Daten und/oder Programme mit der bei der Initialisierung ermittelten Signatur (S) verschlüsselt abgespeichert ist,
**dadurch gekennzeichnet,**
**dass** die Einheit (1) zur Ermittlung der Temperatur der Ummantelung (2) einen Temperaturfühler (6) umfaßt, dessen Signalausgang an den Mikroprozessor (MP) und/oder Rechner (13) der Einheit (1) angeschlossen ist,
- **dass** in dem Mikroprozessor und/oder dem Rechner (13) ein Speicher vorgesehen ist zur Abspeicherung der initial ermittelten Signatur (S) und/oder für die jeweiligen für einzelne Temperaturintervalle ermittelten charakteristischen Signaturwerte (S_{T}) und/oder für Differenzwerte (SΔT) zwischen den jeweiligen charakteristischen Signaturwerten (S_{T}) für einzelne Temperaturintervalle und einer für eine bestimmte Normal-Temperatur der Ummantelung (2) bei der Initialisierung ermittelte Norm-Signatur (S_{NORM}), und
- **dass** die Einheit (1) derart ausgebildet ist,
- **dass** bei der Überprüfung einer vor Inbetriebnahme oder im Betrieb neuerlich ermittelten Signatur der Wert der charakteristischen Signatur (S_{T}) desjenigen Temperaturintervalles zu Vergleichszwecken herangezogen wird, in dem die zum Zeitpunkt der Signaturermittlung gemessene Temperatur der Ummantelung (2) liegt und/oder
- **dass** die Differenzwerte (SΔT) für die Überprüfung der Unversehrtheit der Ummantelung (2) bzw. für die Entscheidung betreffend die Zulässigkeit der Inbetriebnahme der Einheit (1) und/oder das Abschalten derselben herangezogen werden.

13. Anordnung nach Anspruch 12, **dadurch gekennzeichnet, dass** die Einheit (1) eine Prüfeinheit zur Überprüfung einer jeweils vor Betriebsbeginn der Einheit (1) ermittelten Signatur (ζ) bzw. zum Vergleich mit einer bei der Initialisierung ermittelten oder mit einer vor einer vorangehenden Inbetriebnahme ermittelten Signatur aufweist.

14. Anordnung nach Anspruch 12 oder 13, **dadurch gekennzeichnet, dass** der elektrische Widerstand der bezüglich ihrer elektrischen und/oder elektromagnetischen Eigenschaften inhomogen aufgebauten Ummantelung (2) zwischen dem eines Isolators und dem eines metallischen Leiters liegt.

15. Anordnung nach einem der Ansprüche 12 bis 14, **dadurch gekennzeichnet, dass** die Ummantelung (2) aus nicht oder nicht gut miteinander mischbaren Materialien aufgebaut ist und/oder aus zumindest zwei Materialien mit unterschiedlichen elektrischen und/oder elektromagnetischen Eigenschaften und/oder zumindest in einer Dimension inhomogen aufgebaut und/oder aus mehreren Schichten unterschiedlicher Dicke und/oder unterschiedlichen Materialien aufgebaut ist.

16. Anordnung nach einem der Ansprüche 12 bis 15, **dadurch gekennzeichnet, dass** die Signalaufgabestellen (P) und/oder die Messstellen (Q) unregelmäßig über die Ummantelung (2), insbesondere über deren Innenseite, verteilt festgelegt sind.

17. Anordnung nach einem der Ansprüche 12 bis 16, **dadurch gekennzeichnet, dass** die Aufgabeeinrichtungen (11) zumindest eine zumindest eine Strom- und/oder Spannungsquelle mit zumindest einer der festgelegten Signalaufgabestellen (P) verbindende Verteilereinrichtung (19) umfasst, die von dem in der Einheit (1) enthaltenden Mikroprozessor (MP) und/oder Rechner (13) steuerbar bzw. an diesen angeschlossen ist.

18. Anordnung nach einem der Ansprüche 12 bis 17, **dadurch gekennzeichnet, dass** in jeder Messstelle (Q) ein Messsensor angeordnet ist, der gegebenenfalls über einen Analog/Digitalwandler (5) an den in der Einheit (1) enthaltenen Mikroprozessor (MP) und/oder Rechner (13) angeschlossen ist.

19. Anordnung nach einem der Ansprüche 12 bis 18, **dadurch gekennzeichnet, dass** die Einheit (1), der Mikroprozessor (MP) und/oder der Rechner (13) einen Differenzbildner aufweist oder zur Differenzbildung eingerichtet ist, um bei der Initialisierung die Differenzen (ΔS) zwischen einer für eine bestimmte Temperatur der Ummantelung (2) ermittelten Norm-Signatur (S_{NORM}) und den für bestimmte Temperaturintervalle der Ummantelung (2) ermittelten Signaturen (S_{T}) zu berechnen.

20. Anordnung nach einem der Ansprüche 12 bis 19, **dadurch gekennzeichnet, dass** die Einheit (1) oder der Mikroprozessor (MP) und/oder der Rechner (13) zur Ermittlung der Norm-Signatur (S_{NORM}) einen Addierer aufweist oder zum Addieren eingerichtet ist, um die einer gemessenen Temperatur der Ummantelung (2) entsprechende gespeicherte Differenz-Signatur (ΔS) und die für die vorherrschende Temperatur ermittelte Signatur (S_{T}) der Ummantelung (2) zu addieren.

21. Anordnung nach einem der Ansprüche 12 bis 20, **dadurch gekennzeichnet, dass** die Aufgabeeinrichtungen (11) und/oder die Empfangseinrichtung(en) (5) mit den Signalaufgabestellen (P) und den Messstellen (Q) über Leiterbahnen (14) in direktem Kontakt bzw. in direkter leitender Verbindung stehen.

22. Anordnung nach einem der Ansprüche 12 bis 21, **dadurch gekennzeichnet, dass** von den Signalaufgabestellen (P) und/oder den Messstellen (Q) in die Ummantelung (2) unregelmäßig orientierte und/oder gestaltete Leiterbahnen (8) abgehen.

23. Anordnung nach einem der Ansprüche 12 bis 22, **dadurch gekennzeichnet, dass** die Ummantelung (2) direkt auf die zu schützende Fläche(n) der Einheit (1) aufgebracht ist und dass die Ummantelung (2) zumindest Teil der Wand (2') eines zu schützende Gegenstände (15) aufnehmenden Raumes (16) ist, in dem auch die Einheit (1) selbst angeordnet ist.

24. Anordnung nach einem der Ansprüche 12 bis 23, **dadurch gekennzeichnet, dass** zwischen der Ummantelung (2) und der Einheit (1) und/oder zwischen der Ummantelung (2) und einer diese abdeckenden Schicht eine Zwischenschicht oder eine elektrische Isolierschicht angeordnet ist.

25. Anordnung nach einem der Ansprüche 12 bis 24, **dadurch gekennzeichnet, dass** die Anordnung Teil einer Chipkarte ist.

26. Anordnung nach Anspruch 25, **dadurch gekennzeichnet, dass** die Einheit (1) der Chip einer Chipkarte ist, der gemeinsam mit Ein- und Ausgabeeinheiten auf einer Seite oder allseitig oder auf allen Seiten mit Ausnahme der Kontaktflächen von der Ummantelung (2) umgeben ist, wobei zwischen der Ummantelung und dem Kunststoffmaterial der Chipkarte zumindest eine elektrische Isolationsschicht angeordnet ist.

## Claims

1. A method for protecting electronic computing units, processors, processor circuits, micro-processors or chips, or items including such units, against an undesirable access, wherein
- at least that side or surface of the unit (1) comprising at least one processor and/or computer and/or chip or of the item which is exposed to an attack or to spying out is provided or covered at least in part with a shell or protective layer (2),
- electrical and/or electromagnetic signals, preferably current signals and/or voltage signals, defined by said unit (1), being applied and/or have been introduced at at least one invariantly determined signal feeding place (P) to and/or into said shell (2),
- electrical and/or electromagnetic measuring values, preferably measuring values related to resistance, capacity, current, voltage, magnetic fields and/or the course of these measuring values over time, being determined and/or measured at at least one invariantly fixed measuring place (Q) on and/or in said shell by said unit (1) protected by said shell, which has inhomogeneous electrical and/or electromagnetic properties in at least one dimension,
- these measuring and/or signal values, and optionally further measuring values dependent upon the mechanic integrity of said shell (2), being combined to provide a signature (S) characteristic for said shell at the moment of the measurement which, in the case of an integer shell (2) defined by its properties investigated by said signals applied, remains invariant,
and at least part of the data and/or programs, loaded when initialising said unit (1), being coded using said signature determined at the time of said initialisation,
**characterised by**
determining that signature (S_{T}) which is characteristic for a temperature interval of a number of different temperature intervals of said shell (2) at the time of said initialisation, and
using the value of the characteristic signature (S_{T}) of that temperature interval for comparison, when checking a newly determined signature either before starting or in operation, which includes the temperature of said shell (2) at the moment of new determination of the signature.

2. Method according to claim 1, **characterised in that** that signature (S_{T}) is determined which is respectively characteristic for successive temperature intervals.

3. Method according to claim 1 or 2, **characterised in that** determining the signature (S) is done in the course of initialising said unit (1) itself or by said computer, or that said unit (1) newly determines the signature (S) of said shell (2) before starting or before each start and/or during operation of said unit on the basis of the same conditions and procedures as when initialising said unit, or that the signature (S) is newly determined each time when starting, said newly determined signature (S) being used for decoding the data and/or programs memorised in this unit in a coded format.

4. Method according to any of claims 1 to 3, **characterised in that** the signature (S) determined in the course of initialisation after having been used for coding at least part of the subsequently input data and/or programs is rejected or not stored or irrevocably cancelled, or that the signature (S) newly determined in the course of starting is rejected or not stored or irrevocably cancelled after having been used for decoding and/or coding of data and/or programs being either memorised or having been obtained for memorisation.

5. Method according to any of claims 1 to 4, **characterised in that** the selection and order of applying to the existing signal feeding places (P) and the selection and order of sampling from said measuring places (Q), the kind and magnitude of the signals applied to said signal feeding places (P) and the manner of determining said measuring values and forming into a signature (S), are always effected according to an invariably fixed mode by those data and/or programs in said unit (1) to be protected, which have been memorised originally at the time of said initialisation.

6. Method according to any of claims 1 to 5, **characterised in that** at least one or all measuring value(s) either in the shape or size as determined or in a mathematically modified or changed form or after insertion of the measuring value(s) a variable into a HASH function are used for forming said signature (S) or the numerical value of said signature (S).

7. Method according to any of claims 1 to 6, **characterised in that** the unit (1) starts its proper operation or is put into proper operating condition only after determining or using a signature (S) which has either remained unchanged or has been changed solely within predetermined limits.

8. Method according to any of claims 1 to 7, **characterised in that** for manufacturing said shell (2) either different substances or substances which are either immiscible or not well miscible with one another, preferably artificial resins, glass, rubber, on the one hand, and metallic particles, carbon fibres, carbon black particles, on the other hand, are either blended or at least one coating material is applied in a non-uniform manner.

9. Method according to any of claims 1 to 8, **characterised in that** applying signals to the existing signal feeding places (P) and determining said measuring values for initially determining said signature (S) and newly determining or checking the invariancy of said signature (S) is exclusively effected before every start of said unit by the unit (1) protected by said shell (2) itself.

10. Method according to any of claims 1 to 9, **characterised in that**
- after determining the respective signatures (S_{T}) of a number of different, particularly successive, temperature intervals of said shell (2), only the differences (ΔS) between the signatures (S_{T}) determined for the individual temperature intervals and a standard signature (S_{NORM}) determined at the time of said initialisation and at a given normal temperature are memorised in said unit (1),
- that at least part of the data and/or programs loaded onto the unit (1), particularly at the time of said initialisation, are coded with said standard signature (S_{NORM}), and
- that optionally values of the signature difference (ΔS) corresponding to the signature differences (ΔS) of the prevailing temperature of the shell (2) memorised for the individual temperature intervals are taken at the start of said unit (1), and to this value is added the value of the signature (S_{T}) determined at the prevailing temperature, thus determining said standard signature (S_{NORM}) at normal temperature.

11. Method according to any of claims 1 to 10, **characterised in that**, when checking a signature newly determined either before starting or during operation, the value of said standard signature (S_{NORM}) is used for checking the integrity of said shell (2) and/or for the decision concerning the admissibility of starting the unit (1) and/or for switching it off.

12. An arrangement for protecting electronic units (1) which comprises at least one computing unit, a processor unit, a micro-processor and/or a chip, or of such items that include such units (1) against an undesirable access,
- wherein at least that side or surface of the unit (1) which is exposed to an attack is provided or covered by a protecting layer or shell (2) at least in part,
- and said unit (1) comprises at least one applying means (11) by which at least one signal feeding place (P) on and/or in said shell (2) having electrical and/or electromagnetic properties, which are difficult to be identically copied, may be fed with defined electrical and/or electromagnetic signals, preferably current and/or voltage signals,
- and said unit (1) further comprises at least one receiving unit (5) for determining or measuring at least one measuring magnitude or measuring value provoked at at least one or a plurality of measuring place(s) (Q) situated on or in said shell (2) by the signals applied,
- at least one or all of said determined measuring values being used by said unit (1) in the course of its initialisation for determining a signature (S) characteristic for the integrity of said shell (2) and remaining invariant, when said shell is integer,
- said unit (1) further comprising a memory (12) in which at least part of the data and/or programs loaded in the course of initialisation are stored in a coded form by said signature (S) determined during initialisation,
**characterised in that**
- for determining the temperature of said shell (2), said unit (1) comprises a temperature sensor (6) whose signal output is coupled to the microprocessor (MP) and/or computer (13) of said unit (1),
- that a memory is provided within said microprocessor and/or computer (13) for memorising the initially determined signature (S) and/or for the respective characteristic signature values (S_{T}) determined for the individual temperature intervals and/or for difference values (SΔT) between the respective characteristic signature values (S_{T}) for individual temperature intervals and a standard signature (S_{NORM}) determined at the time of said initialisation and at a given certain normal temperature of said shell (2), and
- that said unit (1) is formed in such a way
- that the value of the characteristic signature (S_{T}) of that temperature interval is used for comparison purposes, when checking a newly determined signature before starting or during operation, in which the temperature measured at the moment of signal determination of the shell (2) is
and/or
- that the difference values (SΔT) are used for checking the integrity of the shell (2) or for the decision concerning the admissibility of starting the unit (1) and/or switching it off.

13. Arrangement according to claim 12, **characterised in that** said unit (1) comprises a testing unit for testing a signature (ζ) determined respectively before starting the operation of said unit (1) and/or for comparison with a signature either determined at the time of said initialisation or before a preceding start.

14. Arrangement according to claim 12 or 13, **characterised in that** the electrical resistance of the shell (2), inhomogeneously formed with respect to its electrical and/or electromagnetic properties, is between that of an isolator and that of a metallic conductor.

15. Arrangement according to any of claims 12 to 14, **characterised in that** said shell (2) is formed of materials which are either immiscible or not well miscible with one another and/or of at least two materials of different electrical and/or electromagnetic properties and/or which are built up inhomogeneously in at least one dimension and/or is built up from a plurality of layers of different thickness and/or of different materials.

16. Arrangement according to any of claims 12 to 15, **characterised in that** said signal feeding places (P) and/or said measuring places (Q) are fixed in an irregular distribution over said shell (2), particularly over its inner side.

17. Arrangement according to any of claims 12 to 16, **characterised in that** said applying means (11) comprise at least one distribution means (19), which couples at least one current source and/or voltage source to at least one of said fixed signal feeding places (P), and is controllable by and/or is coupled to said microprocessor (MP) and/or computer (13) comprised by said unit (1).

18. Arrangement according to any of claims 12 to 17, **characterised in that** a measuring sensor is arranged in each measuring place (Q), optionally coupled to said microprocessor (MP) and/or computer (13) comprised by said unit (1) through an analogue/digital converter (5).

19. Arrangement according to any of claims 12 to 18, **characterised in that** said unit (1), said microprocessor (MP) and/or said computer (13) comprise a differentiator or is enabled to differentiate in order to calculate at the time of said initialisation the differences (ΔS) between a standard signature (S_{NORM}) determined for a determined temperature of said shell (2) and the signatures (S_{T}) determined for certain temperature intervals of said shell (2).

20. Arrangement according to any of claims 12 to 19, **characterised in that** said unit (1) or said microprocessor (MP) and/or said computer (13) comprises an adder for determining said standard signature (S_{NORM}) or is enabled to add in order to add a memorised differential signature (ΔS), which corresponds to the measured temperature of said shell (2) and the signature (S_{T}) of said shell (2) determined for the prevailing temperature.

21. Arrangement according to any of claims 12 to 20, **characterised in that** said applying means (11) and/or said receiving means (5) are in direct contact or in direct conductive connection with said signal feeding places (P) and said measuring places (Q) through strip conductors (14).

22. Arrangement according to any of claims 12 to 21, **characterised in that** irregularly oriented and/or shaped strip conductors (8) emerge from said signal feeding places (P) and/or said measuring places (Q) into said shell (2).

23. Arrangement according to any of claims 12 to 22, **characterised in that** said shell (2) is applied directly onto the surface(s) of said unit (1) to be protected, and that said shell (2) is at least a portion of a wall (2') of a space (16) comprising items (15) to be protected in which the unit (1) itself is located too.

24. Arrangement according to any of claims 12 to 23, **characterised in that** an intermediate layer or an electrically isolating layer is interposed either between said shell (2) and said unit (1) and/or between said shell (2) and a layer which covers it.

25. Arrangement according to any of claims 12 to 24, **characterised in that** the arrangement is part of a chip card.

26. Arrangement according to claim 25, **characterised in that** said unit (1) is the chip of a chip card which is coated by said shell (2) in common with input and output units either on one side or on all sides or on all sides with exception of the contact surfaces, at least one electrically isolating layer being between said shell and the plastic material of said chip card.

## Revendications

1. Procédé pour protéger des unités de calcul électroniques, des processeurs, des circuits de processeur, des microprocesseurs ou des puces ou des objets contentant des telles unités contre un accès indésirable, dans lequel
- au moins le côté ou la surface exposé à une attaque ou à l'espionnage de l'unité (1) incluant au moins un processeur et/ou un calculateur et/ou une puce ou de l'objet est pourvu ou couvert d'une enveloppe ou couche protectrice (2) au moins partiellement,
- des signaux électriques et/ou électromagnétiques, préférablement des signaux de courant et/ou de tension, définis par ladite unité (1) étant appliqués et/ou introduits à au moins une place d'application de signaux (P) déterminée d'une manière invariable à l'enveloppe et/ou dans l'enveloppe (2),
- des valeurs mesurées électriques et/ou électromagnétiques, préférablement des valeurs mesurées se référants à la résistance, la capacité, le courant, la tension, aux champs magnétiques et/ou l'écoulement de ces valeurs mesurées, étant déterminées et/ou mesurées à au moins une place de mesurage (Q) déterminée d'une façon invariable sur et/ou dans cette enveloppe par ladite unité (1) protégée par ladite enveloppe, qui a des propriétés électriques et/ou électromagnétiques inhomogènes dans au moins une dimension,
- lesdites valeurs mesurées et/ou valeurs des signaux, et le cas échéant des valeurs mesurées ultérieures, qui dépendent de l'intégrité mécanique de l'enveloppe (2), étant combinées pour former une signature (S) restant invariable et étant caractéristique pour l'enveloppe (2) intègre et définie par ses propriétés inspectées par les signaux appliqués,
- au moins une partie des données et/ou des programmes chargés à l'unité (1) lors de son initiation étant codée en incluant cette signature (S) déterminée lors de l'initiation,
**caractérisé en ce,**
**que** lors de l'initiation et pour un nombre d'intervalles de température différents de l'enveloppe (2) on détermine respectivement la signature (S_{T}) caractéristique pour l'intervalle de température, et
**que** lors de la révision d'une signature déterminée de nouveaux avant d'une mise en marche ou pendant le service, on utilise pour la fin de comparaison la valeur de la signature caractéristique (S_{T}) de cet intervalle de température, dans lequel se trouve la température de l'enveloppe (2) mesurée au moment de la détermination nouvelle de la signature.

2. Procédé selon la revendication 1, **caractérisé en ce que** la signature caractéristique (S_{T}) est déterminée respectivement pour des intervalles de température successives.

3. Procédé selon la revendication 1 ou 2, **caractérisé en ce que** la détermination de la signature (S) est effectué pendant l'initiation de l'unité (1) ou du calculateur, ou qu'une détermination nouvelle de la signature (S) de l'enveloppe (2) est effectuée par l'unité (1) elle-même avant une mise en marche ou avant chaque mise en marche et/ou aussi pendant le service de l'unité à la base des mêmes conditions et procédures comme pendant l'initiation de l'unité, ou que l'on détermine la signature (S) de nouveau lors de chaque mise en marche et on utilise cette signature (S) déterminé de nouveau pour décoder des données et/ou programmes mémorisés d'une manière codée par cette unité.

4. Procédé selon une quelconque des revendications 1 à 3, **caractérisé en ce que** la signature (S) déterminée pendant l'initiation est rejetée ou n'est pas mémorisée ou est éteinte d'une manière irrévocable après l'utilisation pour le codage au moins d'une partie des données et/ou programmes introduits dans la suite, ou que la signature (S) déterminée de nouveau pendant une mise en marche est rejetée ou n'est pas mémorisée ou est éteinte d'une manière irrévocable après l'utilisation pour le décodage et/ou le codage des données et/ou des programmes mémorisés et/ou reçus pour être mémorisés.

5. Procédé selon une quelconque des revendications 1 à 4, **caractérisé en ce que** la sélection et l'ordre de l'application aux places d'application de signaux (P) existantes et la sélection et l'ordre de l'interrogation des places de mesurage (Q), du type et grandeur des signaux appliquées aux places d'application de signaux (P), et la manière de la détermination des valeurs mesurées et de la formation de la signature (S) sont toujours effectuées selon un mode fixé d'une manière invariable par des données et/ou programmes mémorisés originalement pendant l'initiation dans l'unité (1) à protéger.

6. Procédé selon une quelconque des revendications 1 à 5, **caractérisé en ce qu'**au moins une valeur mesurée ou toutes les valeurs mesurées en leurs forme et grandeur déterminées ou en forme modifiée ou changée de façon mathématique ou après introduction de la (des) valeur(s) mesurée(s) dans une fonction HASH comme variable sont utilisées pour former la signature (S) ou de la valeur numérique de la signature (S).

7. Procédé selon une quelconque des revendications 1 à 6, **caractérisé en ce que** l'unité (1) est mise en marche conforme à l'ordre ou est mise dans sa condition de service conforme à l'ordre seulement après la détermination ou l'utilisation d'une signature (S), qui a été inchangée ou a été changée seulement dans des limites donnés.

8. Procédé selon une quelconque des revendications 1 à 7, **caractérisé en ce que** l'on mélange, pour produire l'enveloppe (2), des substances différents ou des substances, qui ne sont pas miscibles ou ne sont pas bien miscibles, préférablement des résines artificielles, de la verre, de la gomme d'une part, et des particules métalliques, des fibres de charbon, des particules de la suie d'autre part, ou que l'on applique au moins un matériau de couchage d'une manière inégale.

9. Procédé selon une quelconque des revendications 1 à 8, **caractérisé en ce que** l'application des signaux aux places d'application de signaux (P) et la détermination des valeurs mesurées pour déterminer initialement la signature (S) et une détermination nouvelle ou une révision de l'invariabilité de la signature (S) avant chaque mise en marche de l'unité est effectuée exclusivement par l'unité (1) elle-même, qui est protégée par l'enveloppe (2).

10. Procédé selon une quelconque des revendications 1 à 9, **caractérisé en ce**
- **qu'**après avoir déterminé les signatures (S_{T}) respectives pour un nombre d'intervalles de température de l'enveloppe (2) différents, particulièrement successives, on mémorise dans l'unité (1) seulement la différence (ΔS) entre les signatures (S_{T}) déterminées pour les intervalles de température individuels et une signature standard (S_{NORM}) déterminée lors de l'initiation à une température normale donnée,
- **qu'**au moins une partie des données et/ou programmes chargés à l'unité (1), particulièrement pendant l'initiation, sont codés en utilisant la signature standard (S_{NORM}), et
- **que**, le cas échéant, on prend les valeurs de la différence de signature (ΔS), qui correspondent aux différences de signatures (ΔS) de la température régnante de l'enveloppe (2) mémorisées pour les intervalles de température individuelles, et additionne à cette valeur la valeur de signature (S_{T}) déterminée à la température régnante, de manière à déterminer ainsi la signature standard (S_{NORM}) à la température normale.

11. Procédé selon une quelconque des revendications 1 à 10, **caractérisé en ce que** lors de la révision d'une signature déterminée de nouveau avant la mise en marche ou pendant le service, on utilise la valeur de la signature standard (S_{NORM}) pour réviser l'intégrité de l'enveloppe (2) et/ou pour la décision concernant l'admissibilité de la mise en marche de l'unité (1) et/ou l'arrêt de celle-ci.

12. Dispositif pour protéger des unités électroniques (1), qui comprennent au moins une unité de calcul, une unité de processeur, un microprocesseur et/ou une puce ou des objets comprenant des telles unités (1), contre un accès indésirable,
- dans lequel au moins une partie du côté ou de la surface de l'unité exposé à une attaque est pourvu ou couvert d'une couche protectrice ou enveloppe (2),
- ladite unité (1) comprenant au moins un moyen d'application (11), par lequel des signaux électriques ou électromagnétiques, de préférence des signaux de courant et/ou de tension, sont applicable à au moins une place d'application de signaux (P) sur et/ou dans l'enveloppe (2) ayant des propriétés électriques et/ou électromagnétiques difficilement imitable d'une manière identique,
- ladite unité (1) comprenant de plus au moins un moyen récepteur (5) pour déterminer ou mesurer au moins une grandeur mesurée ou un valeur mesurée provoquée par les signaux appliquées à au moins une place de mesurage (Q) ou à plusieurs places de mesurage (Q) situées sur ou dans l'enveloppe (2),
- au moins une des valeurs mesurées déterminées ou toutes étant utilisées par l'unité (1) pendant son initiation pour déterminer une signature (S) caractéristique pour l'intégrité de l'enveloppe et restant invariable, si l'enveloppe est intacte,
- l'unité (1) comprenant de plus une mémoire (12), dans laquelle on a mémorisé au moins une partie des données et/ou programmes chargés pendant l'initiation en forme codée avec la signature (S) déterminée lors de l'initiation,
**caractérisé en ce**
- **que** l'unité (1), pour déterminer la température de l'enveloppe (2), comprend un capteur de température (6) dont la sortie de signal est couplée au microprocesseur (MP) et/ou au calculateur (13) de l'unité (1),
- **qu'**une mémoire est prévue dans le microprocesseur (MP) et/ou dans le calculateur (13) pour mémoriser la signature (S) initialement déterminée et/ou pour les valeurs de signature (S_{T}) respectives caractéristiques déterminées pour les intervalles de température individuelles respectives et/ou pour les valeurs différentielles (SΔT) entre les valeurs de signature (S_{T}) caractéristiques respectives pour des intervalles de température individuelles et une signature standard (S_{NORM}) déterminée lors de l'initiation pour une certaine température normale de l'enveloppe (2), et
- **que** l'unité est construite d'une manière
- **que** lors de la révision d'une signature déterminé de nouveau avant la mise en marche ou pendant le service on utilise la valeur de la signature (S_{T}) caractéristique de cet intervalle de température pour une comparaison, dans lequel se trouve la température de l'enveloppe (2) mesurée au moment de la détermination de la signature
et/ou
- **que** l'on utilise les valeurs différentielles (SΔT) pour réviser l'intégrité de l'enveloppe (2) et/ou pour la décision concernante l'admissibilité de la mise en marche de l'unité (1) et/ou l'arrêt de celle-ci.

13. Dispositif selon la revendication 12, **caractérisé en ce que** l'unité (1) comprend une unité de contrôle pour réviser une signature (ζ) déterminée respectivement avant le commencement de service de l'unité (1) et/ou pour la comparaison avec uns signature déterminée lors de l'initiation ou avant une mise en marche précédente.

14. Dispositif selon la revendication 12 ou 13, **caractérisé en ce que** la résistance électrique de l'enveloppe (2) formée d'une manière inhomogène concernant ses propriétés électriques et/ou électromagnétiques se trouve entre celle-ci d'un isolateur et celle-ci d'un conducteur métallique.

15. Dispositif selon une quelconque des revendications 12 à 14, **caractérisé en ce que** l'enveloppe (2) est formée des matériaux, qui ne se mélangent pas ou ne se mélangent pas bien l'un avec l'autre, et/ou d'au moins deux matériaux ayant des propriétés électriques et/ou électromagnétiques différentes et/ou sont formés d'une manière inhomogène dans au moins une dimension et/ou sont formés de plusieurs couches d'une épaisseur différente et/ou des matériaux différents.

16. Dispositif selon une quelconque des revendications 12 à 15, **caractérisé en ce que** les places d'application de signaux (P) et/ou les places de mesurage (Q) sont fixées avec une distribution irrégulière sur l'enveloppe, particulièrement sur son côté intérieur.

17. Dispositif selon une quelconque des revendications 12 à 16, **caractérisé en ce que** le moyen d'application (11) comprend au moins un moyen de distribution (19), qui relie au moins une source de courant et/ou de tension avec au moins une des places d'application de signaux (P) déterminées, et qui est contrôlable par ou relié au microprocesseur (MP) et/ou au calculateur (13) contenu dans l'unité (1).

18. Dispositif selon une quelconque des revendications 12 à 17, **caractérisé en ce que** dans chaque place de mesurage (Q) un capteur de mesure est disposé, qui est, le cas échéant, relié au microprocesseur (MP) et/ou au calculateur (13) contenu dans l'unité (1) au moyen d'un convertisseur analogique-numérique (5).

19. Dispositif selon une quelconque des revendications 12 à 18, **caractérisé en ce que** l'unité (1), le microprocesseur (MP) et/ou le calculateur (13) comprend un différenciateur ou est adapté à différencier pour, lors de l'initiation, calculer des différences (ΔS) entre une signature standard (S_{NORM}) déterminée pour une certaine température de l'enveloppe (2) et les signatures (S_{T}) déterminées pour certaines intervalles de température de l'enveloppe (2).

20. Dispositif selon une quelconque des revendications 12 à 19, **caractérisé en ce que** l'unité (1) ou le microprocesseur (MP) et/ou le calculateur (13) comprend un additionneur ou est adapté à additionner pour déterminer la signature standard (S_{NORM}) et pour additionner la signature différentielle (ΔS) mémorisée, qui correspond à une température mesurée de l'enveloppe (2), et la signature (S_{T}) de l'enveloppe déterminée pour la température régnante.

21. Dispositif selon une quelconque des revendications 12 à 20, **caractérisé en ce que** les moyens d'application (11) et/ou le(s) moyen(s) récepteur (5) sont en contact direct et/ou reliés directement d'une manière conducteur avec les places d'application de signaux (P) et les places de mesurage (Q) au moyen des conducteurs (14).

22. Dispositif selon une quelconque des revendications 12 à 21, **caractérisé en ce que** des conducteurs (8) orientés et/ou formés irrégulièrement sortent des places d'application de signaux (P) et/ou des places de mesurage (Q) à l'enveloppe (2).

23. Dispositif selon une quelconque des revendications 12 à 22, **caractérisé en ce que** l'enveloppe (2) est appliquée directement à la surface (aux surfaces) à protéger de l'unité (1), et que l'enveloppe (2) forme au moins une partie d'une paroi (2') d'un espace (16) recevant les objets à protéger (15), dans lequel l'unité (1) elle-même est aussi disposée.

24. Dispositif selon une quelconque des revendications 12 à 23, **caractérisé en ce qu'**une couche intermédiaire ou une couche isolante électriquement est disposée entre l'enveloppe (2) et l'unité (1) et/ou entre l'enveloppe (2) et une couche, qui couvre celle-ci.

25. Dispositif selon une quelconque des revendications 12 à 24, **caractérisé en ce qu'**il forme partie d'une carte à puce.

26. Dispositif selon la revendication 25, **caractérisé en ce que** l'unité (1) est la puce d'une carte à puce, qui est entourée, ensemble avec les unités d'input et d'output, par l'enveloppe (2) soit sur un côté, soit sur tous les côtés ou sur tous les côtés à l'exception des surfaces de contact, au moins une couche d'isolation électrique étant disposée entre l'enveloppe et le matériau plastique de la carte à puce.
